# EUROPEAN PATENT APPLICATION

(11) **EP 3 540 354 A1**
(43) Date of publication of application: **18.09.2019**
(21) Application number: 18161892.7
(22) Date of filing: 15.03.2018
(51) Int. Cl.: F28F 1/12, F28F 3/02, B21D 53/02, H01L 23/367

(54) **CORRUGATED FIN COMPOSITE FOR A HEAT EXCHANGER**

(71) Applicant: Mahle International GmbH, 70376 Stuttgart (DE)
(72) Inventor: MAGNIER, Gilles, 90110 Rougemont-le-Chateau (FR); MARLIER, Eric, 67120 Kolbsheim (FR); MISS, Pascal, 67600 Sélestat (FR); STOECKEL, Jérôme, 68540 Bollwiller (FR)
(74) Representative: BRP Renaud & Partner mbB Rechtsanwälte Patentanwälte Steuerberater

(57) **Abstract**

The invention relates to a corrugated fin composite for a heat exchanger (12) comprising at least two interconnected corrugated fins, wherein the corrugated fins each have fins (18), which are arranged in a row in a transvers direction (22) of the corrugated fin (10) and which can be flown through in a longitudinal direction (20), wherein the fins (18) have flanks (30), which run transversely to the transverse direction (22) from an upper side (24) of the corrugated fin (10) to an underside (26) of the corrugated fin (10), and which are interconnected by means of connecting sections (34), wherein a fin division (46) of the corrugated fins, which corresponds to a period length of the corrugated fins, is smaller than twice a fin width (36), which corresponds to a width of the connecting sections (34).

To provide for a simple production, it is proposed that the at least two corrugated fins (10) are adhered to one another, that the connecting sections (34) have exterior bearing surfaces (28), that the bearing surfaces (28) of the corrugated fins (10) serve as adhesive surface (33), to which adhesive (13) is applied to adhere the corrugated fins (10).

## Description

The invention relates to a corrugated fin composite for a heat exchanger comprising at least two interconnected corrugated fins, according the preamble of claim 1. The invention further relates to a heat exchanger comprising at least one such corrugated fin composite and a method for producing such a corrugated fin composite.

Usually, such corrugated fins have fins, which are arranged in a row in a transvers direction of the corrugated fin and which can be flown through in a longitudinal direction, wherein the fins have flanks, which run transversely to the transverse direction from an upper side of the corrugated fin to an underside of the corrugated fin, which are interconnected by means of connecting sections. If a heat transfer capacity is required, which cannot be generated solely by means of a corrugated fin, such corrugated fins are interconnected to form corrugated fin bonds. For this purpose, contact sheets are used, which are placed between the two corrugated fins, which are to be connected. Even though a stable corrugated fin composite can be attained through this, the heat transfer between the interconnected corrugated fins is impacted.

The present invention is based on the object of providing an improved or at least an alternative embodiment of a corrugated fin composite, which in particular provides for an improved heat transfer of two interconnected corrugated fins.

According to the invention, this object is solved by means of the independent claims. Advantageous further developments are subject matter of the dependent claims.

The invention is based on the general idea of providing a contact surface, which is as large as possible, between the two corrugated fins. A particularly good heat transfer between the corrugated fins and thus from heating elements to the corrugated fin and from the corrugated fin to the fluid, which flows through the corrugated fin, can be attained in this way. According to the invention, provision is thus made for a fin division of the corrugated fins, which corresponds to a period length of the corrugated fins, to be smaller than twice a fin width, which corresponds to a width of the connecting sections. Provision is further made according to the invention for the at least two corrugated fins to be adhered to one another, wherein the connecting sections have exterior bearing surfaces, which serve as adhesive surface and to which adhesive is applied to adhere the corrugated fins. It is attained in this way that the connecting sections and thus the bearing surfaces, which run on the upper side of the corrugated fin and on the underside of the corrugated fin, cover a large portion of the surface area of the upper side and of the underside, so that the corrugated fin has a large adhesive surface and heat transfer surface to the connected corrugated fin. This provides for a strong adhesive composite between the corrugated fins, wherein a good heat conductivity is simultaneously attained between the connected corrugated fins. In addition, an increased heat transfer to heat sinks or heat sources, which are connected to the corrugated fin composite, can also be attained through this.

In the description and the enclosed claims, the width of the connecting sections is measured across the external dimensions of the connecting sections, that is, the wall thickness of the flanks is included in the width of the connecting sections.

In the description and the enclosed claims, the period length of the corrugated fin is understood to be a distance in the transverse direction of the corrugated fin, after which the shaping of the corrugated fin repeats itself.

A favorable solution provides for the fin division of the corrugated fins to be smaller than three-quarters of the fin width. Particularly preferably, the fin division of the corrugated fins is equal to the fin width. A particularly large adhesive surface and heat transfer surface can thus be formed between the interconnected corrugated fins.

A particularly favorable option provides for the connecting sections to run in a curved manner, wherein the connecting sections have a larger radius in a central area than in edge areas, at which the connecting sections transition into the flanks. A large portion of the connecting sections can thus in fact serve as bearing surface, so that the heat transfer surface between the connected corrugated fins is particularly large.

It is advantageous when the radius in the edge area is smaller than 0.5 mm. A particularly large portion of the connecting sections can thus in fact serve as bearing surface, so that the heat transfer surface between the connected corrugated fins is particularly large.

An advantageous solution provides for adjacent flanks to be arranged at an incline to one another. It can be attained in this way that the connecting sections of the corrugated fin follow one another particularly closely, so that the largest possible surface areas are formed as contact surface to the heating elements on the upper side and on the underside in the corrugated fin.

A further advantageous solution provides for gills to be arranged one behind the other in the longitudinal direction of the corrugated fin. A fluidic exchange between the flow channels formed by the corrugated fin can be attained in this way across the entire length of the flanks in the longitudinal direction. A particularly good homogenization of the flow of the fluid, which flows through the corrugated fin, can thus be attained, whereby the heat transfer between the fluid and the corrugated fin, in turn, is particularly good.

A further particularly advantageous solution provides for adjacent gills to be separated from one another by means of a slit and to be formed by rotating the webs, which are formed thereby. This is an option, which can be produced easily, for forming the gills. The gills are thus inclined to the flow direction of the fluid, which flows through the corrugated fin, and protrude beyond the wall thickness of the flanks of the corrugated fin, so that the gills can siphon fluid from the fluid flow and supply it to an adjacent flow channel, so that a particularly good heat exchange between the corrugated fin and the fluid is possible.

A favorable alternative provides for a direction of rotation of the webs of the gills to vary, in particular for the direction of rotation of the webs in one half of the corrugated fin, based on a longitudinal direction, to be opposite to the direction of rotation of the webs in the other half of the corrugated fin. A particularly favorable exchange of the fluid can be attained in this way between adjacent flow channels by means of the corrugated fin, whereby the heat exchange between the corrugated fin and the fluid, which flows through the corrugated fin, is improved in turn.

A further favorable alternative provides for the webs to be rotated about a gill angle of between 10° and 40°, preferably between 15° and 35°, particularly preferably between 20° and 30°. The siphoning of the fluid can be made possible particularly easily in this way. In the description and the enclosed claims, a gill angle is understood to be an angle of the web to the flank or to the longitudinal direction of the corrugated fin.

An advantageous option provides for a fin height to be larger than twice the fin width, wherein the fin height is defined by a distance of the upper side to the underside of the corrugated fin. This results in a particularly favorable geometry of the corrugated fin.

The invention is further based on the general idea of providing a heat exchanger comprising at least one corrugated fin composite according to the above description and a heat source and/or sink, wherein the heat source and/or sink is arranged on an underside or upper side of such a corrugated fin of the corrugated fin composite. Heat can be transferred from the heat source and/or sink to a fluid, which flows through the corrugated fin composite, or vice versa, in this way.

A further advantageous option provides for the heat exchanger to have at least two corrugated fin bonds and for the heat source and/or sink to be arranged between two corrugated fin bonds in each case. Heat can be guided particularly well between the heat source and/or sink and the corrugated fin bonds in this way, so that the heat transfer between the heat source and/or sink and the fluid, which flows through the corrugated fins, can occur in a particularly favorable manner.

A further particularly advantageous option provides for the heat source and/or sink to be formed by means of a pipe, in particular oval pipe or flat pipe, through which a fluid flows. Heat, for example from a coolant or a heating agent, which flows through the pipe, can thus be transferred to the fluid, which flows through the corrugated fin, or vice versa.

A favorable solution provides for the heat source and/or sink to be formed by means of an electrical heating element. Heat generated by means of electrical energy can be transferred to the fluid, which flows through the corrugated fin, in this way.

The invention is further based on the general idea of producing a corrugated fin composite according to the above description. According to the invention, provision is made for adhesive to be applied to at least one bearing surface in the case of at least one of the corrugated fins, and for the at least two corrugated fins to be placed against one another, wherein the bearing surface, to which adhesive was applied, is placed against a bearing surface of another corrugated fin to establish an adhesive bond between the corrugated fins. Adhering is a cost-efficient method to connect objects with one another. In contrast to a solder connection, significantly lower temperatures are required, so that energy can be saved on the one hand. On the other hand, temperature-sensitive objects can thus also be connected to the corrugated fin composite. By means of the increased surface area of the bearing surfaces, a good heat transfer can be attained in spite of the adhesive bond, so that the advantages of the corrugated fin composite can be optimally utilized.

A favorable solution provides for the at least two corrugated fins to be preformed in an endless process by means of a roller and for the corrugated fins to be adapted to the final shape in a post-processing step. The production in the endless process by means of a roller is particularly favorable, but the desired shape of the corrugated fin cannot be attained solely by means of a shaping by means of a roller, so that a post-processing of the corrugated fin is necessary. In particular the forming of the connecting sections and the trimming to the required dimensions.

A further favorable solution provides for the gills to be formed in the flanks in response to the preforming of the corrugated fins and for the connecting sections to be embodied with a smaller radius, which is enlarged in the post-processing step, in response to the preforming. The most important features of the corrugated fins are formed by means of the preforming in this way. The subsequent post-processing step then only serves for the adaptation to the respective heating element. In particular an adaptation to a curved or bent surface of the electrical heating element is possible.

A particularly favorable solution provides for the final angles of the flanks to be adjusted relative to one another and to the connecting sections in response to the post-processing step. The desired shape of the corrugated fin can be attained particularly easily in this way.

Further important features and advantages of the invention follow from the subclaims, from the drawings, and from the corresponding figure description by means of the drawings.

It goes without saying that the above-mentioned features and the features, which will still be explained below, cannot only be used in the respective specified combination, but also in other combinations or alone, without leaving the scope of the present invention.

Preferred exemplary embodiments of the invention are illustrated in the drawings and will be explained in more detail in the description below, whereby identical reference numerals refer to identical or similar or functionally identical components.

In each case schematically:
- Fig. 1: shows a sectional illustration through a corrugated fin of a corrugated fin composite according to the invention,
- Fig. 2: shows a perspective illustration of the corrugated fin from Fig. 1,
- Fig. 3: shows a detailed illustration of the area A from Fig. 2,
- Fig. 4: shows a sectional illustration along the sectional plane B-B through the corrugated fin from Fig. 1,
- Fig. 5: shows a sectional illustration through a corrugated fin composite according to the invention,
- Fig. 6: shows a sectional illustration through a heat exchanger according to the invention comprising a corrugated fin composite according to the invention,
- Fig. 7: shows a side view in the longitudinal direction onto a corrugated fin before and after a post-processing step,
- Fig. 8: shows a side view along the longitudinal direction of a second embodiment of the corrugated fin and
- Fig. 9: shows a side view in the longitudinal direction of a third embodiment of the corrugated fin.

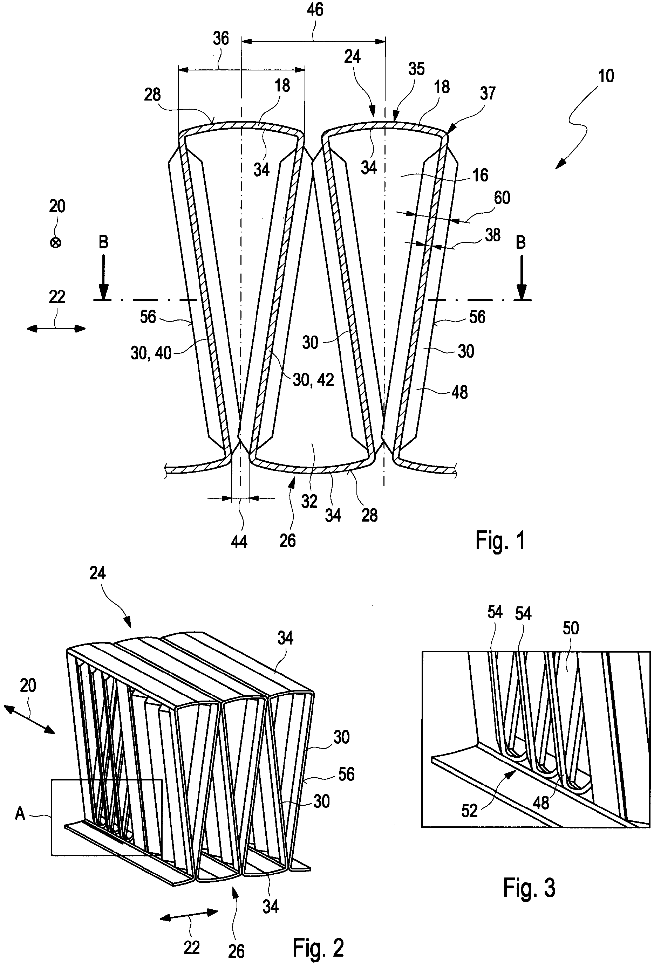

A corrugated fin 10 illustrated in Fig. 1 is used in a corrugated fin composite 11 for a heat exchanger 12. In particular for a heat exchanger 12, which transfers heat from a heat source and/or sink 13, for example from a heating element 14, in particular electrical heating element 14, to a fluid 16, which flows through the corrugated fin 10. Such heat exchangers 12 are required in particular to heat the interior of energy-efficient vehicles, in which the exhaust heat of the drive is not sufficient to heat the passenger compartment. Such energy-efficient vehicles are, for example, hybrid vehicles, in particular plug-in hybrid vehicles comprising range extender, electric vehicles or vehicles comprising particularly efficient internal combustion engines, such as, for example, Diesel engines.

The corrugated fin 10 has fins 18, which can be flown through in the longitudinal direction 20, in particular flown through by the fluid 16. The fins 18 are arranged in a row in a transvers direction 22. The transverse direction 22 is in particular perpendicular to the longitudinal direction 20.

The fins 18 have an upper side 24 and an underside 26, on which bearing surfaces 28 are formed in each case, to which the heating element 14 can be applied to transfer heat from the heating element 14 to the corrugated fin 10.

The corrugated fin 10 has a plurality of flanks 30, which run from the upper side 24 to the underside 26. The flanks 30 are then in contact with the fluid 16, which flows through the corrugated fin 10. Flow channels 32, through which the fluid 16 can flow through the corrugated fin 10, are formed between the flanks 30.

The flanks 30 are in each case connected to at least one further flank 30, most of the flanks, which are not arranged on the edge, are in each case connected to two further flanks 30, wherein the flanks 30 are connected to a further flank 30 on one side (upper side 24 or underside 26), and are connected to another flank 30 on the other side. A plurality of flanks 30 are interconnected in a row in this way.

The flanks 30 are interconnected by means of connecting sections 34. The connecting sections 34 extend from a flank 30 to an adjacent further flank 30, which is connected to the one flank 30. The connecting sections 34 thus run either on the upper side 24 or on the underside 26 and thereby form the bearing surfaces 28, against which a further corrugated fin 10 or the heating elements 14 can be applied. Via the connecting sections 24, the heat can be transferred from the heating elements 14 to the flanks 30, which, in turn, can emit heat to the fluid 16. The connecting sections 34 also limit the flow channels 32, so that the flow channels 32 have a substantially triangular cross section.

The connecting sections 34 have a width 36, which is measured in the transverse direction 22 of the corrugated fin 10. The width 36 of the connecting sections 34 is defined via the external dimensions. A wall thickness 38 of the flanks 30 is thus part of the width 36 of the connecting sections 34. The width 36 of the connecting sections 34 is also referred to as fin width 36.

The connecting sections 34 run in a curved manner. In a central area 35, the connecting sections 34 thereby have a central radius and an edge radius in the edge area 37, in which the connecting sections 34 transition into the flanks 30. The central radius is significantly larger than the edge radius, so that the bearing surfaces 28 are formed in the central area 35.

The central radius of the connecting section 34 preferably lies in a range of from 2 mm to infinity. It is thus possible that the connecting section 34 also runs straight in the central area. The final radius in the central area, however, only results in the installed state, i.e. under the impact of the tensioning in the installed state. For example, the central areas 35 of the connecting sections 34 are adapted by means of the further corrugated fin 10 or heat source and/or sink 13, which is applied to the corrugated fin 10, so that the connecting sections 34 lie flat against the connecting sections 34 of the further corrugated fin 10 or against the heat source and/or sink 13.

The course of an individual fin 18 of the corrugated fin 10 begins with a first flank 40, which extends from the underside 26 to the upper side 24 and which transitions into a connecting section 34 on the upper side 24.

On the upper side 24, the connecting section 34 extends substantially parallel to the transverse direction 22 all the way to a second flank 42. The second flank 42 extends from the connecting section 34 on the upper side 24 all the way to the underside 26, where the second flank 42 transitions into a further connecting section 34. A fin of the corrugated fin is thus defined by means of two flanks 30 and two connecting sections 34.

A fin distance 44 is defined as a distance between the first flanks 40 and the second flank 42 on the underside 26 of the corrugated fin. The flanks 30 run at an angle to one another, wherein two flanks 30, which are interconnected, have a larger distance from one another on the connecting section 34 than on the other side of the corrugated fin 10, on which the flanks 30 have the fin distance 44 to one another. According to the invention, the fin distance 44 is smaller than the fin width 36. A fin division 46 corresponds to a distance of two identical points of two consecutive fins 18. The fin division 46 thus corresponds to a period length of the corrugated fin 10.

The flanks 30 are equipped with gills 48, which are arranged in a row in the longitudinal direction 20. The gills 48 forms apertures 50 through the flanks 30, through which fluid can be exchanged between two adjacent flow channels 32. A good mixing of the fluid 16, which flows through the corrugated fin, is thus attained, whereby the heat transfer between the corrugated fin 10 and the fluid 16 is improved, in turn.

The gills 48 are formed by slits 52 in the flanks 30, which are arranged in a row in the longitudinal direction 20. Webs 54, which are rotated about their own axis, are formed between the slits 52, so that the webs 54 protrude from a flank surface 56 and thus form the apertures 50 through the flanks 30. Due to the fact that the webs 54 of the gills 48 protrude from the flank surfaces 56, the gills can siphon fluid 16 from the flow channels 32 and can introduce it into the adjacent flow channel 32.

The gills 48 are inclined by a gill angle 58 with respect to the flank surface 56, thus with respect to the longitudinal direction 20. The gill angle 58 preferably lies in a range of between 15° and 35°.

To improve the exchange of the fluid between the flow channels 32, the direction of rotation, in which the webs 54 of the gills are rotated, can vary across the length of the corrugated fin 10. On one half of the corrugated fin, the gills 48 are rotated in the one direction, for example, and in the other half of the corrugated fin, they are rotated in the other direction.

A gill flank width 60 of the gills 48 is determined by the distance of the slits 52 relative to one another and the gill angle 58 relative to the longitudinal direction 20. The gill flank width 60 is thereby defined by the expansion of the gills 48 in a direction perpendicular to the flank surface area 56.

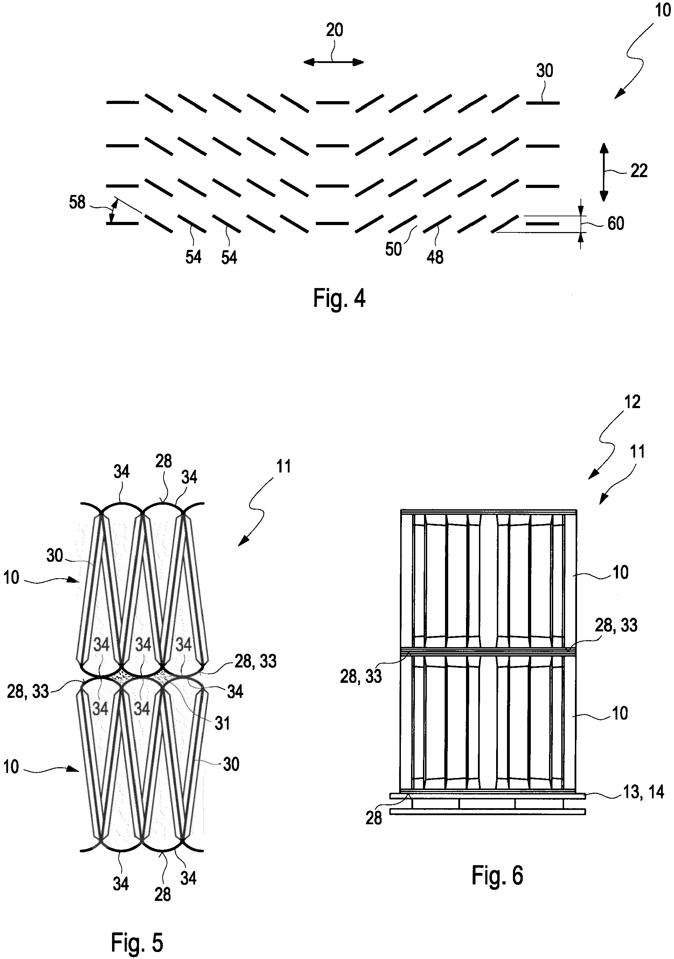

A corrugated fin composite 11 illustrated in Fig. 5 in an exemplary manner, has a plurality of, for example two, corrugated fins 10, which are interconnected by means of an adhesive bond. The two corrugated fins 10 are arranged on one another in such a way that the bearing surfaces 28 of the two corrugated fins 10 face one another. Adhesive 31, which effects the substance-to-substance bond between the bearing surfaces 28 and thus between the corrugated fins 10, is arranged between the respective bearing surfaces 28. These bearing surfaces 28 thus serve as adhesive surfaces 33.

A heat exchanger 12, which is illustrated in Fig. 6 in an exemplary manner, has at least one corrugated fin composite 11 and a heat source and/or sink 13. The heat source and/or sink 13 is in thermal contact with the bearing surface 28 of one of the corrugated fins 10 of the corrugated fin composite 11. Heat can thus be transferred between the heat source and/or sink 13 and the corrugated fin composite 11 and thus the fluid 16, which flows through the corrugated fins 10.

In the alternative, the heat source and/or sink 13 can be arranged between two corrugated fin bonds 11. Due to the fact that the heat source and/or sink 13 is arranged between two corrugated fin bonds 11, the heat can be transferred from the heat source and/or sink 13 to the corrugated fins 10 of the corrugated fin bonds 11 and thus to the fluid 16 in a particularly effective manner.

The heat source and/or sink 13 can be formed by a pipe, in particular flat pipe, through which a heating fluid can be guided in order to heat up the corrugated fin 10. In the alternative illustrated in Fig. 6, the heat source and/or sink 13 is formed by means of a heating element 14, in particular an electrical heating element, which converts electrical energy into heat, in order to heat up the corrugated fin 10 and thus the fluid 16.

The corrugated fin 10 is initially produced in an endless process by means of a roller. The flanks 30 and the connecting sections 34 are formed by means of the roller, wherein the connecting sections 34 are embodied with a central radius 35, which is too small, and the flanks 30 still run substantially parallel to one another. The corrugated fin can thus be removed from the roller. In response to the preforming of the corrugated fin 10 by means of the roller, the gills 48 are also introduced into the flanks 30.

In a further post-processing step, the corrugated fin 10 is brought into the final form, which means that the connecting sections 34 are formed in such a way that the central radius is enlarged and is in particular larger than the edge radius 37. In the case of the post-processing step, the corrugated fin 10 is also adapted to the size of the heat exchanger 12.

To produce the corrugated fin composite 11, two corrugated fins 10 are adhered to one another across the bearing surfaces 28. The bearing surfaces 28 thus serve as adhesive surface 33. For this purpose, an adhesive 31 is applied to the upper side 24 or the underside 26 of one of the corrugated fins 10 on the bearing surface 28 thereof. The second corrugated fin 10 is then applied with one of its bearing surfaces 28 to the bearing surface 28 of the first corrugated fin 10, which is provided with adhesive 31. If necessary, a contact pressure can be exerted to establish the adhesive bond.

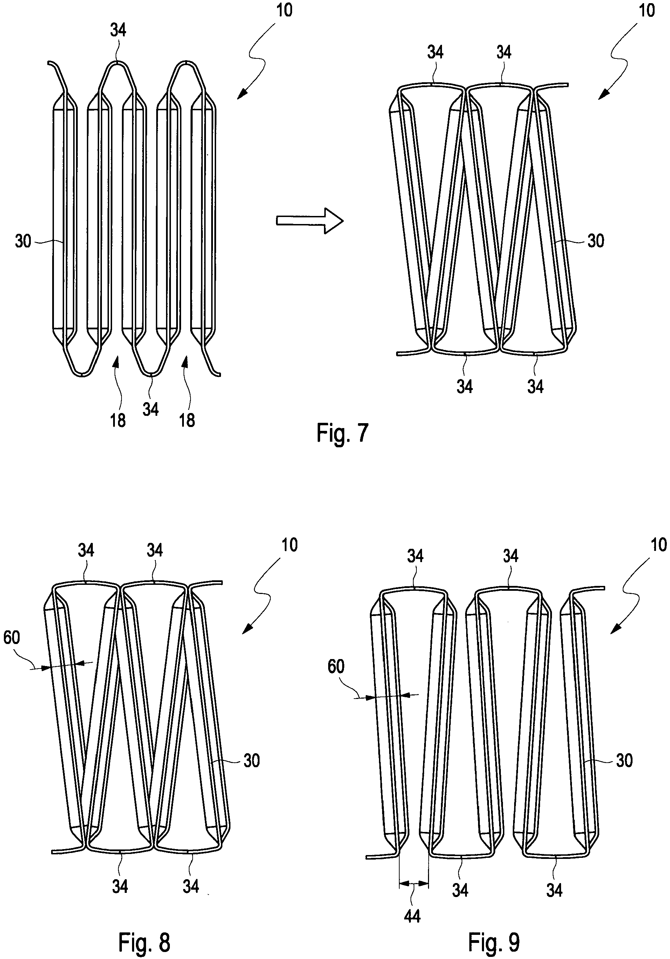

A second embodiment of the corrugated fin 10 illustrated in Fig. 8, differs from the first embodiment of the corrugated fin 10 illustrated in Figs. 1 to 7 in that the fin distance 44 is zero, which means that flanks 30, which lie against one another, touch one another on the non-connected side.

Moreover, the second embodiment of the corrugated fin 10 illustrated in Fig. 8, corresponds to the first embodiment illustrated in Figs. 1 to 7 with regard to structure and function, to the above description of which reference is made in this regard.

A third embodiment of the corrugated fin 10 illustrated in Fig. 9 differs from the first embodiment of the corrugated fin 10 illustrated in Figs. 1 to 7 in that the fin distance 44 corresponds approximately to the gill flank width 60.

Moreover, the third embodiment of the corrugated fin 10 illustrated in Fig. 9 corresponds to the first embodiment of the corrugated fin 10 illustrated in Figs. 1 to 7 with regard to structure and function, to the above description of which reference is made in this regard.

## Claims

1. A corrugated fin composite for a heat exchanger (12) comprising at least two interconnected corrugated fins,
- wherein the corrugated fins each have fins (18), which are arranged in a row in a transvers direction (22) of the corrugated fin (10) and which can be flown through in a longitudinal direction (20),
- wherein the fins (18) have flanks (30), which run transversely to the transverse direction (22) from an upper side (24) of the corrugated fin (10) to an underside (26) of the corrugated fin (10), and which are interconnected by means of connecting sections (34),
- wherein a fin division (46) of the corrugated fins, which corresponds to a period length of the corrugated fins, is smaller than twice a fin width (36), which corresponds to a width of the connecting sections (34),
**characterized in**
- **that** the at least two corrugated fins (10) are adhered to one another,
- **that** the connecting sections (34) have exterior bearing surfaces (28),
- **that** the bearing surfaces (28) of the corrugated fins (10) serve as adhesive surface (33), to which adhesive (13) is applied to adhere the corrugated fins (10).

2. The corrugated fin composite according to claim 1,
**characterized in**
**that** the fin division (46) of the corrugated fins is smaller than three-fourths of the fin width (36).

3. The corrugated fin composite according to claim 1 or 2,
**characterized in**
**that** the fin division (46) of the corrugated fins is equal to the fin width (36).

4. The corrugated fin composite according to one of claims 1 to 3,
**characterized in**
**that** the connecting sections (34) run in a curved manner, wherein the connecting sections (34) have a larger radius in a central area (35) than in edge areas (37), at which the connecting sections (34) transition into the flanks (30).

5. The corrugated fin composite according to one of claims 1 to 4,
**characterized in**
**that** adjacent flanks (30) are arranged at an incline to one another.

6. The corrugated fin composite according to one of claims 1 to 5,
**characterized in**
**that** a fin height is larger than twice the fin width (36), wherein the fin height is defined by a distance of the upper side (24) to the underside (26) of the corrugated fin (10).

7. A heat exchanger comprising at least one corrugated fin composite according to one of claims 1 to 6, and a heat source and/or sink (13),
**characterized in**
**that** the heat source and/or sink (13) is arranged on an underside (26) or upper side (24) of such a corrugated fin (10) of the corrugated fin composite (11).

8. The heat exchanger according to claim 7,
**characterized in**
**that** the heat exchanger (12) has at least two corrugated fin composites (11), and that the heat source and/or sink (13) is in each case arranged between two corrugated fin composites (11).

9. The heat exchanger according to claim 7 or 8,
**characterized in**
- **that** the heat source and/or sink (13) is formed by mean of a pipe, in particular oval pipe or flat pipe, through which a fluid flows, or
- **that** the heat source and/or sink (13) is formed by means of an electrical heating element (14).

10. A method for producing a corrugated fin composite (11) according to one of claims 1 to 6,
**characterized in**
- **that** adhesive (31) is applied to at least one bearing surface (28) in the case of at least one of the corrugated fins (10), and
- **that** the at least two corrugated fins are placed against one another, wherein the bearing surface, to which adhesive (31) was applied, is placed against a bearing surface of another corrugated fin to establish an adhesive bond between the corrugated fins.

11. The method according to claim 10,
**characterized in**
- **that** the at least two corrugated fins (10) are preformed in an endless process by means of a roller,
- **that** the corrugated fins (10) are adapted to the final shape in a post-processing step.

12. The method according to claim 10 or 11,
**characterized in**
**that**, in response to the preforming, the connecting sections (34) are embodied with a smaller radius, which is enlarged in the post-processing step.

13. The method according to one of claims 10 to 12,
**characterized in**
**that** the final angles of the flanks (30) are adjusted relative to one another and to the connecting sections (34) in response to the post-processing step.
